# EUROPEAN PATENT APPLICATION

(11) **EP 2 479 015 A1**
(43) Date of publication of application: **25.07.2012**
(21) Application number: 11192859.4
(22) Date of filing: 09.12.2011
(51) Int. Cl.: B29C 45/37, H01L 51/52, H01L 51/00, H01L 51/44, B29D 11/00

(54) **Method of molding structures in plastic substrate**

(30) Priority: 19.01.2011 IN 1300002011
(71) Applicant: Moser Baer India Ltd., 110020 New Delhi (IN)
(72) Inventor: Ter Meulen, Jan Matthijs, 110020 New Dehli (IN); Peters, Patrick, 110020 New Dehli (IN); Prins, Erik Jan, 110020 New Dehli (IN)
(74) Representative: Beck & Rössig European Patent Attorneys

(57) **Abstract**

A method of manufacturing a substrate, characterized by a first surface and a second surface, for use in a semiconductor device is provided. The method includes providing a mold having a first template and/or a second template corresponding to a first texture and a second texture respectively. Then, the method includes injection molding a material for the substrate in the mold, to form the substrate, such that the material is injection molded to create the first texture on the first surface and/or the second texture on the second surface. The first texture and/or the second texture facilitate light extraction or light trapping in the semiconductor device.

## Description

### FIELD OF INVENTION

The invention disclosed herein relates, in general, to semiconductor devices. More specifically, the present invention relates to manufacturing of injection molded substrates in the semiconductor devices.

### BACKGROUND

Semiconductor materials are commonly used as electroluminescent materials in Organic Light Emitting Devices (OLEDs) and as photovoltaic materials in Organic Photovoltaic Devices (OPVs).

OLEDs and/or OPVs usually include layers of the semiconductor materials for carrying out their functionality. In OPVs for example, the semiconductor materials on receiving solar radiation, generate excitons, which get diffused through the layers of the semiconductor materials. This then gets separated into free charge carriers as electrons and holes and a pair of electrodes are provided on both sides of the layers of the semiconductor materials to collect the free charge carriers and help in generation of electric current.

Similarly in OLEDs for example, when a voltage is applied across the layers of the semiconductor materials, electrons and holes are injected from their respective electrodes. The electrons and holes recombine in the layers of the semiconductor materials and form excitons, thereby emitting light.

Therefore, in functioning of semiconductor devices like the OLEDs and the OPVs, light management is a very critical aspect that substantially affects the efficiency of such devices.

Generally, a refractive index of the layers of the semiconductor materials is greater than a refractive index of a substrate in the OLEDs and OPVs. In the OLEDs, due to this difference in the refractive indices, emitted light gets reflected back from the substrate, through the layers of semiconductor materials, thereby reducing the percentage of the emitted light that can be extracted. Also, due to a difference in the refractive indices of the substrate and an ambient medium in which the OLEDs are used, some light gets reflected back into the substrate at the interface between the substrate and the ambient medium. Thereby, further decreasing the efficiency of the OLEDs. Similarly in the OPVs, light trapping is a major factor affecting its efficiency. Hence, a path of light in the OPVs needs to be increased in order to increase its absorption.

To increase the efficiency of such devices, lacquer layers with light management textures are added to such devices at the interfaces between different refractive index materials. For example, an OLED may have a light extraction texture on a lacquer layer deposited between the layers of the semiconductor materials and the substrate or the substrate and the ambient medium, and an OPV device may have a light trapping texture on a lacquer layer deposited between the layers of the semiconductor materials and the substrate.

However, addition of the lacquer layer to the OLEDs and the OPVs increases the cost of manufacturing such devices. Also, the materials of the lacquer layer tend to contaminate the layers of the semiconductor materials by solvents released during the manufacturing process. Additionally in OLEDs, since the lacquer layer is provided on the substrate, therefore, they tend to come in between the substrate and an encapsulating cover. This may reduce the effectiveness of the encapsulation and allow moisture to enter the OLEDs, thereby contaminating the device. Also, presence of the lacquer layer is highly undesirable in areas where the electrodes are deposited on the semiconductor layers, as any presence of lacquer in these areas may cause delamination or permeation of water or air through the lacquer.

In light of the above discussion, there is a need for an improvement in the current OPVs and OLEDs in order to eliminate one or more drawbacks of the prior art.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1a and 1b illustrate a stack of layers in an exemplary OLED and an exemplary OPV, respectively, in accordance with the state of the art prior to the present invention (i.e. prior art);
FIG. 2 illustrates an exemplary mold used for injection molding a substrate, in accordance with an embodiment of the present invention;
FIG. 3 illustrates an exemplary view of a first die and a second die of a mold used for injection molding a substrate, in accordance with an embodiment of the present invention;
FIG. 4a, 4b, 4c and 4d illustrate an exemplary texture that can be provided in a die of a mold, in accordance with some embodiments of the present invention;
FIG. 5 shows an exemplary texture formed on a first surface of a substrate, in accordance with an embodiment of the present invention;
FIG. 6a and 6b illustrate a stack of layers in an exemplary OLED and an exemplary OPV, respectively, in accordance with an embodiment of the present invention;
FIG. 7 is a flow chart describing an exemplary process of texturing a substrate by injection molding, in accordance with an embodiment of the present invention; and
FIG. 8 is a flow chart describing an exemplary method of manufacturing a semiconductor device, in accordance with another embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The present invention provides a method of manufacturing a substrate for use in a semiconductor device like an OLED or an OPV, such that the substrate has a light extraction texture or a light trapping texture. The method includes, applying injection molding to form the substrate by using a mold that has a first template corresponding to a first texture and a second template corresponding to a second texture. The first texture and the second texture can act as a light trapping and/or a light extraction texture. When the substrate is manufactured using this method, then there is no need to deposit an additional light extraction or light trapping layer on the substrate, thereby reducing the cost of the semiconductor device. Also, the substrate formed by injection molding can replace the usually used glass substrate, thereby providing additional cost benefit. In one exemplary embodiment, when the substrate has to be used in an OLED, then a mold having templates corresponding to both internal and external light extraction textures can be used. Use of such a substrate helps in eliminating two deposition processes, corresponding to deposition of an internal light extraction and an external light extraction, from the manufacturing process of a semiconductor device thereby saving cost of the semiconductor device.

In an embodiment of the present invention, a method of manufacturing a substrate for use in a semiconductor device is provided, such that the substrate is characterized by a first surface and a second surface. The method includes providing a mold having a first template corresponding to a first texture and/or a second template corresponding to a second texture. The method includes injection molding a material for making the substrate in the mold, to form the substrate, such that the material is injection molded to create the first texture on the first surface and/or the second texture on the second surface. The first texture and/or the second texture facilitate light extraction and/or light trapping in the semiconductor device where the substrate may be used.

In some embodiments of the present invention, a semiconductor device is provided. The semiconductor device includes an injection molded substrate having a first surface and a second surface. The substrate is such that the first surface includes a first texture and/or the second surface includes a second texture. The first texture and/or the second texture are configured to facilitate light extraction and/or light trapping in the semiconductor device. The semiconductor device further includes a first electrode on the substrate, one or more semiconductor layers on the first electrode, a second electrode on the one or more semiconductor layers. These layers are then encapsulated between the substrate and a cover substrate to form a semiconductor device.

In some embodiments of the present invention, a refractive index of the substrate is substantially equal to or greater than a refractive index of one or more semiconductor layers of the semiconductor device for optical homogeneity.

In some embodiment of the present invention, the material for making the substrate is selected from the group including plastic, polycarbonate, polyethylene terephthalate (PET), and polyethylene naphthalate (PEN).

In another embodiment of the present invention, the semiconductor device is an Organic Light Emitting Device (OLED), wherein the substrate forms a base layer of the OLED, and wherein the OLED has one or more semiconductor layers disposed on the substrate.

In yet another embodiment of the present invention, the second texture is capable of preventing reflection of light into the one or more semiconductor layers at an interface between the substrate and the one or more semiconductor layers, and wherein the first texture prevents reflection of light into the substrate at an interface between the substrate and an ambient medium.

In another embodiment of the present invention, the semiconductor device is an Organic Photovoltaic Device (OPV), wherein the substrate forms a base layer of the OPV, and wherein the OPV has one or more semiconductor layers disposed on the substrate.

In yet another embodiment of the present invention, the second texture is capable of preventing reflection of light into the substrate at an interface between the substrate and the one or more semiconductor layers, and wherein the first texture prevents reflection of light into an ambient medium at an interface between the substrate and an ambient medium.

### DESCRIPTION OF THE EXEMPLARY EMBODIMENTS

Before describing the present invention in detail, it should be observed that the present invention utilizes a combination of method steps and apparatus components related to a method of manufacturing a semiconductor device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

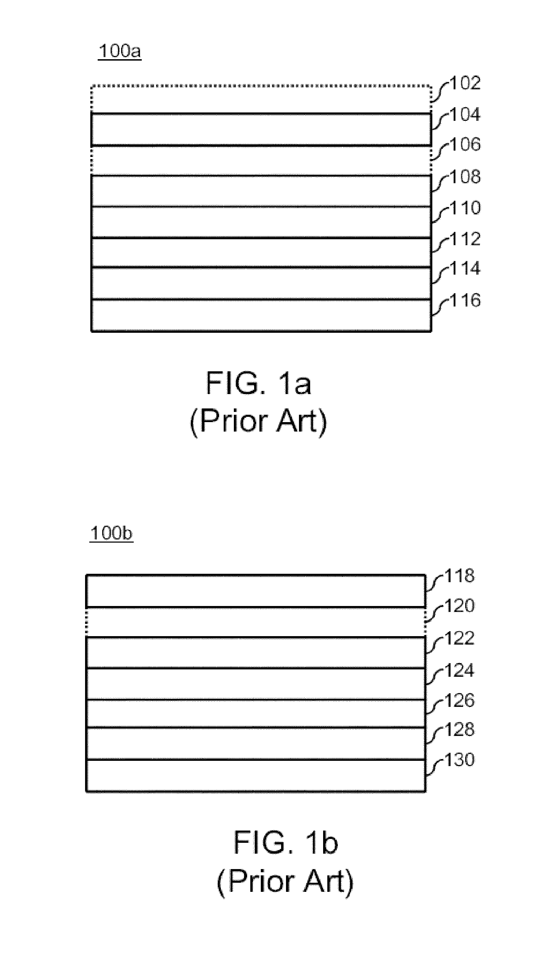

Referring now to the drawings, there is shown in FIG. 1a, a stack of layers in an exemplary OLED 100a as known in the state of the art, prior to the present invention. The OLED 100a is shown to include an external light extraction layer 102, a transparent substrate 104, an internal light extraction layer 106, a first electrical contact 108, one or more semiconductor layers 110 and 112, a second electrical contact 114 and a cover substrate 116, which encapsulates the internal light extraction layer 106, the first electrode 108, the one or more semiconductor layers 110 and 112 and the second electrode 114 between itself and the transparent substrate 104. Each layer of the OLED 100a, apart from the external light extraction layer 102 and the internal light extraction layer 106, can be coated or otherwise applied on the adjacent layer to implement the present invention.

For the purpose of the description, the OLED 100a has been shown to include only those layers that are pertinent to the description of the invention. However, it should be understood that the invention is not limited to the layers listed above. In some cases, the OLED 100a may include additional layers to enhance efficiency or to improve reliability, without deviating from the scope of the invention.

The transparent substrate 104 provides strength to the OLED 100a, and also acts as an emissive surface of the OLED 100a when in use. The examples of the transparent substrate 104 include, but are not limited to, glass, flexible glass, polyethylene terephthalate (PET), polyethylene naphthalate (PEN), and other transparent or translucent material.

The first electrical contact 108 and the second electrical contact 114 are used to apply a voltage across the one or more semiconductor layers 110 and 112. The first electrical contact 108 and can be implemented with, for example, a transparent conductive oxide (TCO). TCOs are doped metal oxides, examples of TCOs include, but are not limited to, Aluminum-doped Zinc Oxide (AZO), Indium Zinc Oxide (IZO), Boron doped Zinc Oxide (BZO), Gallium doped Zinc Oxide (GZO), Fluorine doped Tin Oxide (FTO) and Indium doped Tin Oxide (ITO). Further, the second electrical contact 114 can be implemented with metals with appropriate work function to make injection of charge carriers, for example, calcium, aluminum, gold, and silver.

The one or more semiconductor layers 110 and 112 can be implemented with any organic electroluminescent material such as a light-emitting polymer, evaporated small molecule materials, light-emitting dendrimers or molecularly doped polymers.

Light incident from a high refractive index material onto an interface with a lower refractive index material or medium undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Due to the same reason, when the light emitted by the semiconductor layer 110 or 112 reaches their interface with the transparent substrate 104, a substantial amount of light is reflected back into the semiconductor layers 110 and 112.

Presence of an internal light extraction layer 106 having a texture that is capable of changing the propagation direction of the light emitted by the one or more semiconductor layer 110 or 112 at their interface with the substrate 104 helps to reduce the reflection (or TIR) of the light back into the OLED 100a. The texture on the internal light extraction layer 106 may include geometries having dimensions in the order of the wavelength of the light to facilitate the change in propagation direction of the emitted light by diffraction. The texture on the internal light extraction layer 106 may also include geometries having larger dimensions than the wavelength of the light to facilitate the change in propagation direction of the emitted light by refraction. Therefore, presence of an internal light extraction layer 106 having textures to act as the absorbing and the scattering entities which eliminates or reduces the TIR, which further increases the efficiency of the OLED 100a. In a similar manner, the external light extraction layer 102 reduces or eliminates the TIR at an interface between the transparent substrate 104 and an ambient medium.

In another exemplary embodiment, a hole transfer layer (not shown in the Figures) may also be deposited on the first electrical contact 108 before depositing the semiconductor layer 110. The hole transfer layer is capable of enhancing a flow of holes from the first electrical contact 108 to the semiconductor layers 110, and thereby increase an efficiency of the OLED 100a.

Similarly, in yet another exemplary embodiment, an electron transfer layer (not shown in the Figures) may also be deposited on the semiconductor layer 112 before depositing the second electrical contact 114. The electron transfer layer is capable of enhancing a flow of electrons from the second electrical contact 114 to the semiconductor layer 112, and thereby increase an efficiency of the OLED 100a.

Referring now to FIG. 1b, there is shown a stack of layers in an exemplary OPV 100b, in accordance with an embodiment of the present invention. The OPV 100b is shown to include a transparent substrate 118, a light trapping layer 120, a first electrical contact 122, one or more semiconductor layers 124 and 126, a second electrical contact 128 and a cover substrate 130.

In the OPV 100b, the light falling on the one or more semiconductor layers 124 and 126 enable generation of electricity through the semiconductor layers 124 and 126, which is extracted into external circuits by the first and second electrical contacts 122 and 128. In the OPV 100b, the light trapping layer 120 is provided to increase an optical path of the light transmitted in to the OPV 100b.

Although presence of lacquer layers for light extraction and light trapping in devices like OLED and OPV is desirable. However, use of these layers increases the cost of manufacturing of such devices. Also, presence of these layers is undesirable at areas where a substrate and a cover substrate join, and at areas where electrical contacts are deposited on the semiconductor layers, as presence of the lacquer material used in these layers may cause delamination or permeation of water or air through these layers. This in turn may cause corrosion and adversely affect operation of such devices (OLED or OPV). The present invention provides solution to these problems by providing a substrate that includes a light extraction and/or a light trapping texture. This will allow devices like OLED and OPV to save on manufacturing cost of the layers for light extraction and light trapping. Also, it will minimize the problem of permeation of water, air and other contaminants caused earlier due to presence of the layers for light extraction and light trapping.

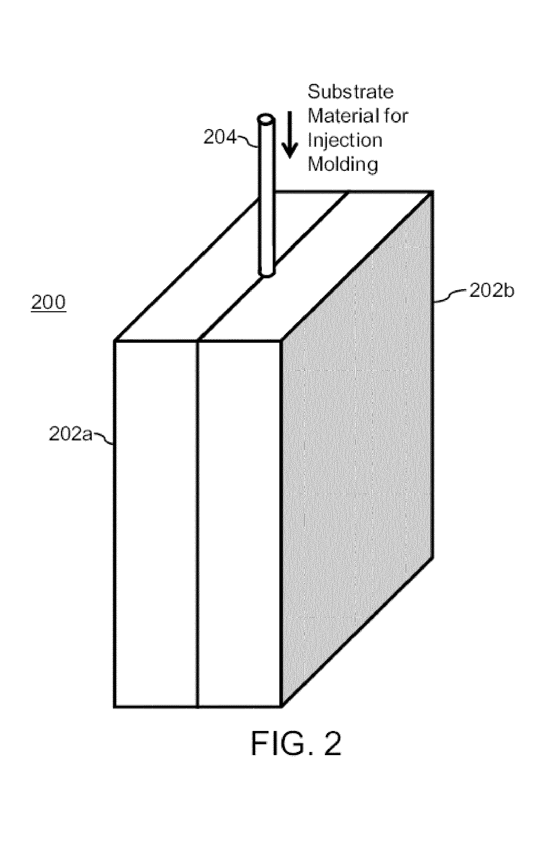

Referring now to FIG. 2, there is shown in FIG. 2 an exemplary mold 200 used for injection molding a substrate, in accordance with an embodiment of the present invention. Those ordinarily skilled in the art will appreciate that the mold 200 may include a greater or a fewer number of components or regions than those shown in FIG. 2. The mold 200 may include components or regions that are not shown here and are not germane to various embodiments of the present invention.

The mold 200 is shown to include a first die 202a, a second die 202b, and a nozzle 204. According to the invention, a material for making a substrate, in a molten state, can be injected into a cavity defined between the first die 202a and the second die 202b via the nozzle 204. Thereafter, the molten material for making the substrate is cooled to form the substrate. The mold 200 may include an in-built cooling mechanism, for example, a cooling jacket/cavity to facilitate cooling. A texture based on the configuration of the cavity is formed on the substrate. In an embodiment, the texture formed on the substrate can be a light extraction and/or a light trapping texture. The material for making the substrate is usually a thermoplastic material. An example of the material includes, but is not limited to, plastic, polycarbonate, polyethylene terephthalate (PET), polyethylene naphthalate (PEN) and other transparent thermoplastic material. An example of a material for the mold 200 includes, but is not limited to, iron, steel, stainless steel, aluminum alloy, and brass.

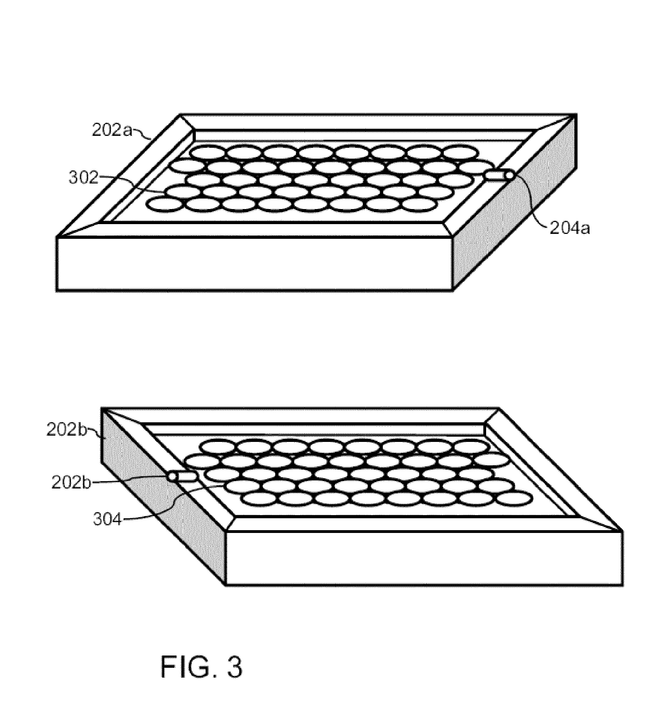

Moving on to FIG. 3, there is shown in Fig. 3 an exemplary view of the first die 202a and the second die 202b, in accordance with an embodiment of the present invention. The first die 202a is shown to include a first template 302 corresponding to a first texture and a part 204a of the nozzle 204. Similarly, the second die 202b is shown to include a second template 304 corresponding to a second texture and a part 204b of the nozzle 204. An example of a material for the first die 202a and the second die 202b includes, but is not limited to, iron, steel, stainless steel, aluminum alloy, and brass.

The substrate formed using the mold 200 is characterized by a first surface and a second surface. The material for making the substrate is injection molded in the mold 200, such that the first texture is formed on the first surface of the substrate and the second texture is formed on the second surface of the substrate. In some embodiment, the material for making the substrate may be molded such that a texture is formed on only one surface of the substrate.

In real life applications, for example in an OLED, the first texture and the second texture may facilitate light extraction and enable the first surface and the second surface to act as an external light extraction layer and an internal light extraction layer respectively. Similarly, in case of an OPV, the first texture and the second texture may facilitate light trapping.

For example, in the OLEDs to facilitate light extraction, there has to be a change in a light propagation direction. The texture provided to the substrate will cause the change in the light propagation direction. The texture can bring about a change in the light propagation direction by either diffraction or refraction. The texture having dimensions in the order of a wavelength of the light, usually change the light propagation direction by diffraction. An example of the texture that change the light propagation direction by diffraction include, but is not limited to, a 1D grating and a 2D grating. The texture having dimensions larger than a wavelength of the light, usually change the light propagation direction by refraction. Examples of the texture that change the light propagation direction by refraction include, but are not limited to, a lens, a cone, and a pyramid.

Usually, the texture facilitating external and internal light extraction can change the light propagation direction by diffraction or refraction and thereby help in eliminating or reducing the TIR. However, the texture facilitating internal light extraction, in most cases, can change the light propagation direction by diffraction and the texture facilitating external light extraction, in most cases, can change the light propagation direction by refraction.

In addition to the second texture, the second die 202b of the mold 200 can also include one or more grooves in form of gutters. Shape of these gutters corresponds to an electrical circuitry that can be received in the shape formed by the one or more grooves on the second surface of the substrate.

These one or more grooves are configured to receive electrical circuitry which is usually required in cases of large area semiconductor devices. Conductivity provided by a TCO based electrode layer of the semiconductor device is often not sufficient, leading to a voltage drop in the large area semiconductor devices. This voltage drop can be prevented by providing the electrical circuitry in addition to the TCO layer. The electrical circuitry can be in the form of a grid of highly conductive metal lines or busbars or electrical gridlines or circuits that are capable of providing an electric current path across entire surface of the substrate and the TCO layer.

However, at the same time the top surface of the second texture and the electrical circuitry should be at a similar height in order to ensure there are no gaps between the surface of the second texture and subsequent layers. This can be maintained by providing one or more grooves in the form of gutters in the second die 202b of the mold 200 along with the second texture. The one or more grooves are so formed that they do not protrude out of a surface of the second texture and perfectly correspond to the shape of the electrical circuitry, thereby providing a substantially uniform surface for subsequent deposition. This also helps in preventing any inhomogeneity in thickness of subsequent layers. In some embodiments the one or more grooves are designed such that they have a width ranging from 20 to 100 microns and a depth ranging from 2 to 30 microns.

Providing the one or more grooves in the second die 202b also helps in providing a higher aspect ratio of the grooves resulting in narrower gridlines which are less visible. Further, an additional step of providing the one or more grooves is saved making the process simple and low cost.

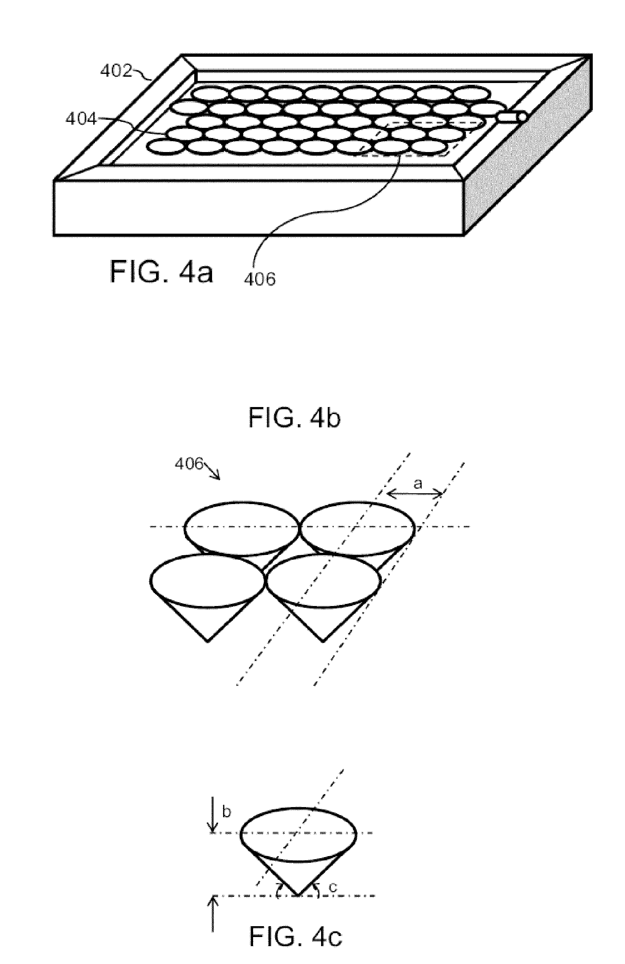

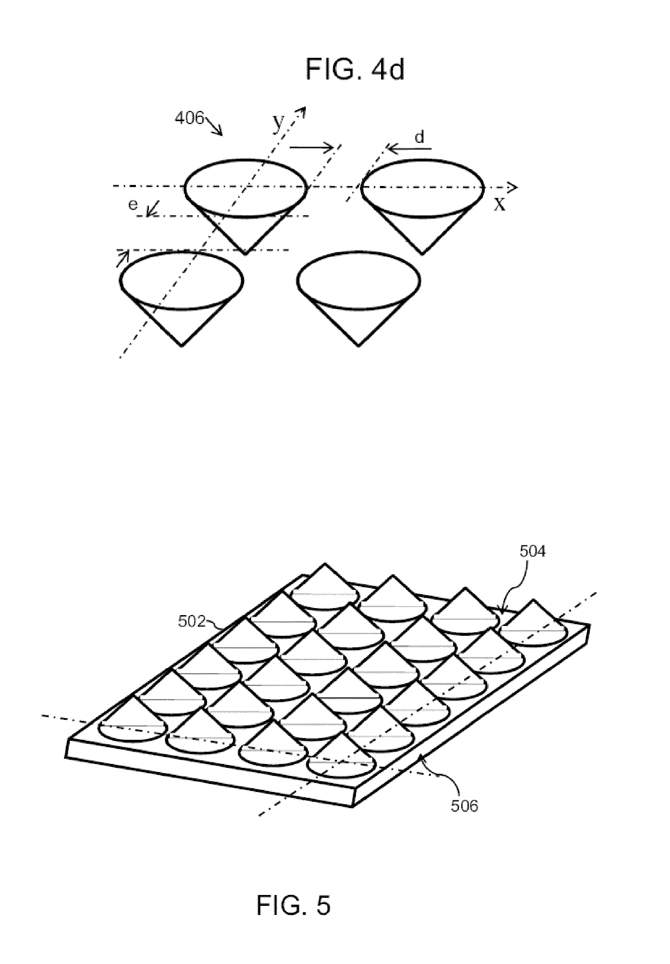

Moving on, FIG. 4a is an illustration of an exemplary die 402 including an exemplary template 404 corresponding to an exemplary texture. There is also shown in FIG. 4a, a section 406 of the template 402. The section 406 will be utilized in FIGs. 4b, 4c and 4d to describe an exemplary texture, in accordance with some embodiments of the invention.

The die 402 is similar in nature to the first die 202a and the second die 202b described in conjunction with FIG.2. Also, the die 402 can be a part of a mold that may be used to form a substrate according to the present invention.

The section 406, in accordance with an embodiment of the present invention, is shown to include four inverted pyramids which provide the template 404 with its corresponding texture. In this case, the texture that will be formed on a surface of the substrate will be in the form of a plurality of pyramids. However, those ordinarily skilled in the art will appreciate that the template may correspond to other such textures that provide light extraction/light trapping feature, without deviating from the scope of the invention.

The texture illustrated in FIGs. 4b, 4c and 4d can change the light propagation direction using refraction. However, those ordinarily skilled in the art will appreciate that the other such textures, for example, a lens, a 1D grating, a 2D grating etc, that provide light extraction/light trapping feature may be applied in a similar manner, without deviating from the scope of the invention.

In an embodiment, a radius 'a' of individual pyramids in the texture can range from 5 microns to 250 microns, a height 'b' of the individual pyramid in the texture may range from 10 microns to 500 microns, and an apex angle 'c' may range from 30o to 150o_{.} However, those ordinarily skilled in the art will appreciate that the individual pyramids may be of other appropriate dimensions that allow them to carry out their required function, without deviating from the scope of the present invention.

In another embodiment, an individual pyramid may be separated from an adjacent individual pyramid by a distance 'd' along the x-axis and a distance 'e' along the y-axis of the section 406. In an embodiment, the distance 'd' and 'e' may range from 0 to 200 microns. However, those ordinarily skilled in the art will appreciate that the adjacent individual pyramids may be separated by any other appropriate distance that allows them to carry out their required function, without deviating from the scope of the present invention.

In an embodiment, when the light propagation direction is changed using diffraction, the dimensions of a texture usually range from 200 nm to 400nm. Similarly, a distance between adjacent textures along the x-axis and the y-axis range from 500nm to 700nm. However, those ordinarily skilled in the art will appreciate that the texture may be of any other dimension and be separated from the adjacent texture by any other appropriate distance, that allows the texture to carry out its required function, without deviating from the scope of the present invention.

Moving on to FIG. 5, there is shown an exemplary texture formed on an exemplary first surface 504 of an exemplary substrate 502, in accordance with an embodiment of the present invention. For ease in understanding of the invention, the texture is shown only on the first surface 504 of the substrate 502. However, those ordinarily skilled in the art will appreciate that a texture can also be formed on the second surface 506 of the substrate 502. Also, it should be appreciated that the elements in this figure have been illustrated for simplicity and clarity and are not necessarily drawn to scale. For example, the dimensions of the texture shown in the figure may be exaggerated, relative to the substrate 502, in order to improve the understanding of the present invention.

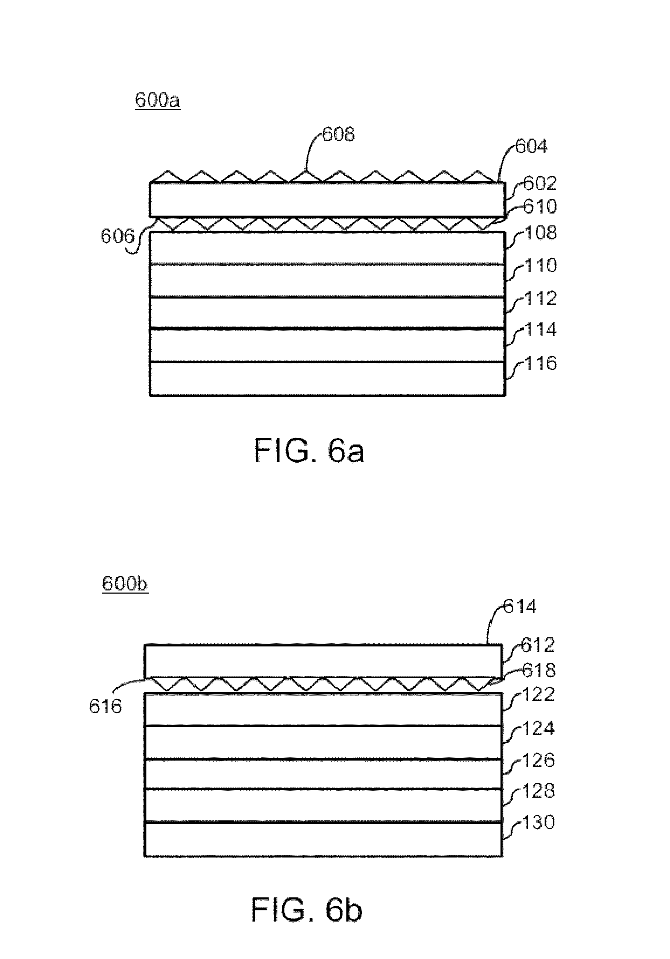

There is shown in FIG. 6a, a stack of layers in an exemplary OLED 600a, in accordance with an embodiment of the present invention. The OLED 600a is shown to include a substrate 602 having a first surface 604 and a second surface 606. The first surface 604 includes a first texture 608 and the second surface 606 includes a second texture 610. The first surface 604 including the first texture 608 acts as an external light extraction layer and the second surface 606 including a second texture 610 acts as an internal light extraction layer. Therefore, the OLED 600a developed according to the present invention can function without the need of separate external and light extraction layers. [0066] Other layers in the stack of layers in the OLED 600a are similar to those in the OLED 100a described in FIG. 1a, and include the first electrical contact 108, the one or more semiconductor layers 110 and 112, the second electrical contact 114 and the cover substrate 116.

Some real life examples of the OLED 600a can include, but are not limited to, Organic Light Emitting Diode (OLED), White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode, Bottom Emitting Organic Light Emitting Diode, Fluorescence doped Organic Light Emitting Diode (FOLED) and Phosphorescent Organic Light Emitting Diode (PHOLED).

The substrate 602 provides strength to the OLED 600a, and also acts as an emissive surface of the OLED 600a when in use. The examples of the material that can be used to form the substrate 602 include, but are not limited to, plastic, polycarbonate, polyethylene terephthalate (PET), polyethylene naphthalate (PEN) and other such thermoplastic material that are transparent. Further, the substrate 602 is optically transparent, i.e., the substrate 602 allows an incident light to pass through it.

In an embodiment, the substrate 602 can also be made of a material having a refractive index substantially equal to or greater than that of the one or more semiconductor layers 110 and 112. An example of such a material can include, but is not limited to polyethylene naphthalate (PEN) This improves optical homogeneity, i.e. eliminate or minimize the TIR of the light back into the OLED 600a, which occurs when a refractive index of the substrate 602 is lesser than a refractive index of the one or more semiconductor layers 110 and 112. In a case when the refractive index of the material of the substrate 602 is substantially equal to or greater than the refractive index of the one or more semiconductor layers 110 and 112, the first surface 604 of the substrate 602 may be provided with the first texture 610 providing external light extraction and the second surface 608 may not include a texture for providing internal light extraction as the TIR is already eliminated or minimized.

In an embodiment, the second texture 610 on the second surface 606 enables the substrate 602 to change the light propagation direction by diffraction and thereby helping in eliminating or reducing the TIR and causes the light to pass through the second surface 606. Examples of the second texture 610 that change the light propagation direction by diffraction include textures having dimensions in the order of the wavelength of the light.

In another embodiment, the second texture 610 on the second surface 606 enables the substrate 602 to change the light propagation direction by refraction and thereby helping in eliminating or reducing the TIR and causes the light to pass through the second surface 606. Examples of the second texture 610 that change the light propagation direction by refraction include textures having dimensions larger than the wavelength of the light.

In a similar manner, the first texture 608 reduces or eliminates the TIR at an interface between the substrate 602 and an ambient medium. However, in most cases the first texture 608 changes the light propagation direction by refraction. Examples of such first texture 608 include textures having dimensions larger than the wavelength of the light.

For example in case of light extraction, the light emitted by the one or more semiconductor layers 110 and 112 on reaching the second texture 610, is allowed to pass through to the substrate 602. The second texture 610 causes the light to undergo refraction but prevents the light from being reflected back into the one or more semiconductor layers 110 and 112. Also, the first texture 608 allows the light to pass through the substrate 602 into the ambient medium. The first texture 608 causes the light to undergo refraction but prevents the light to be reflected back into the OLED 600a.

In an exemplary embodiment, a hole transfer layer (not shown in the Figures) may also be deposited on the first electrical contact 108 before depositing the one or more semiconductor layer 110 and 112. The hole transfer layer is capable of enhancing a flow of holes from the first electrical contact 108 to the semiconductor layer 110, and thereby increase an efficiency of the OLED 600a.

Similarly, in yet another exemplary embodiment, an electron transfer layer (not shown in the Figures) may also be deposited on the semiconductor layer 112. The electron transfer layer is capable of enhancing a flow of electrons from the second electrical contact 114 to the semiconductor layer 112, and thereby increase an efficiency of the OLED 600a.

In FIG. 6a, the OELD 600a is depicted as a stack of planar layers. However, in another embodiment, the second texture providing internal light extraction can propagate through the OLED 600a, such that all the layers may include a similar texture.

Referring now to FIG. 6b, there is shown a stack of layers in an exemplary OPV 600b, in accordance with an embodiment of the present invention. The OPV 600b is shown to include a substrate 612 having a first surface 614 and a second surface 616. The second surface 616 includes a second texture 618 and the first surface 614 does not include a texture. The second surface 616 including a second texture 618 acts as a light trapping layer. However, those ordinarily skilled in the art will appreciate that a texture can also be formed on the first surface 614 of the substrate 612. The OPV 600b developed according to the present invention can function without the need of a separate light trapping layer.

Other layers in the stack of layers in the OPV 600b are similar to those in the OPV 100b described in FIG. 1b, and include a first electrical contact 122, one or more semiconductor layers 124 and 126, a second electrical contact 128 and a cover substrate 130.

In the OPV 600b, the light falling on the semiconductor layers 124 and 126 enable generation of electricity through the semiconductor layers 124 and 126, which is extracted into external circuits by the first and second electrical contacts 122 and 128. In the OPV 600b, the second texture 618 is provided to increase an optical path of the light transmitted in to the OPV 600b. For example in case of light trapping, the light entering the substrate 612 from the ambient medium on reaching the second texture 618, is allowed to pass through to the one or more semiconductor layers 124 and 126. The first texture 608 causes the light to undergo refraction but prevents the light to be reflected back into an ambient medium from where the light enters.

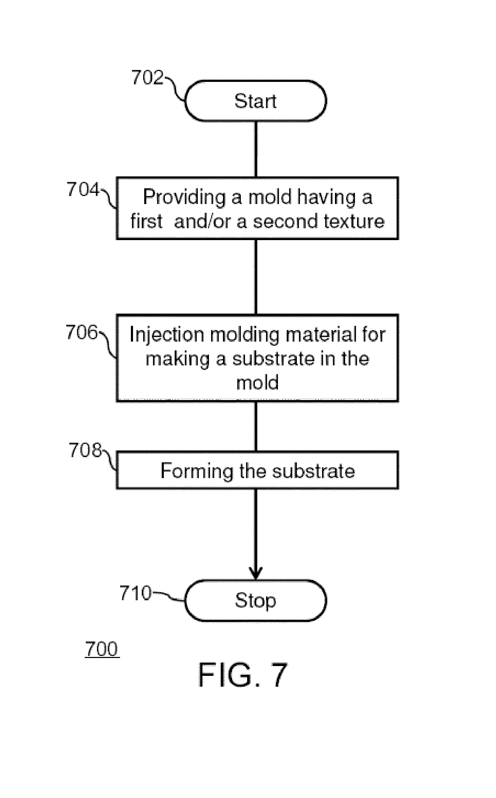

Referring now to FIG. 7, a texturing process 700 for texturing a substrate, for example, the substrate 602, is provided. To describe the method 700, reference will be made to FIGs. 2, 3, 4, 5, and 6, although it is understood that the method 700 can be implemented in any other suitable environment. Moreover, the invention is not limited to the order in which the steps are listed in the method 700. Further, it will also be apparent to those ordinarily skilled in the art that the method 700 may include one or more additional steps for further enhancement of the effectiveness of the method 700, however, are not essential to the method 700, in accordance with the present invention.

The method is initiated at step 702. At step 704, a mold, for example, the mold 200, is provided. The mold 200 includes the first die 202a and the second die 202b. The first die 202a includes the first template 302 corresponding to the first texture and the second die 202b includes the second template 304 corresponding to the second texture. The mold 200 is formed when the first die 202a and the second die 202b are closed, thereby forming a cavity in the mold, the cavity being defined by the first texture on one side and the second texture on the other side.

In an embodiment, the first texture and the second texture can be a light extraction and/or a light trapping texture. In another embodiment, the mold 200 may be provided with only one texture, i.e. either the first texture or the second texture. The first texture on the first die 202a and the second texture on the second die 202b can be produced using any method selected from the group of engraving, milling, lithography and the like.

Thereafter, at step 706, a material for making a substrate, for example, the substrate 602, is injection molded in the mold 200. In an embodiment, the material for making the substrate 602 is injected in a molten state, into the mold 200 via the nozzle 204. The cavity in the mold 200 is filled by the material and thereafter a pressure is maintained to compensate for any material shrinkage. The examples of the material for making the substrate 602 include, but are not limited to, plastic, polycarbonate, polyethylene terephthalate (PET), polyethylene naphthalate (PEN) and other such thermoplastic material that are transparent. In an embodiment, the substrate 602 can also be made using a material having a refractive index substantially equal to or greater than that of the one or more semiconductor layers 110 and 112. This improves optical homogeneity, i.e. eliminate or minimize the TIR of the light back into the OLED 600a, which occurs when a refractive index of the substrate 602 is lesser than a refractive index of the one or more semiconductor layers 110 and 112. In a case when the refractive index of the material of the substrate 602 is substantially equal to or greater than the refractive index of the one or more semiconductor layers 110 and 112, the first surface 604 of the substrate 602 may be provided with the first texture 610 providing external light extraction and the second surface 608 may not include a texture for providing internal light extraction as the TIR is already eliminated or minimized.

Thereafter, at step 708, the substrate 602 is formed. The molten material starts cooling on coming in contact with the mold 200. The molten material is at a temperature above its glass transition temperature and the mold 200 is at a temperature below the glass transition temperature of the molten material. The molten material cools and solidifies, whereas the mold 200 maintains its temperature. Further, the mold 200 is usually made of a metallic material having high thermal conductivity, which allows the molten material to cool rapidly and form the substrate 602. Also, since the temperature of the mold is more or less maintained, the method 700 can have short cycle times as an additional cooling step is not required.

In another embodiment, additional coolants may be used to cool down the molten material. The mold 200 may include an in-built cooling mechanism, for example, a cooling jacket/cavity to facilitate cooling.

Thereafter, the method 700 terminates at step 710.

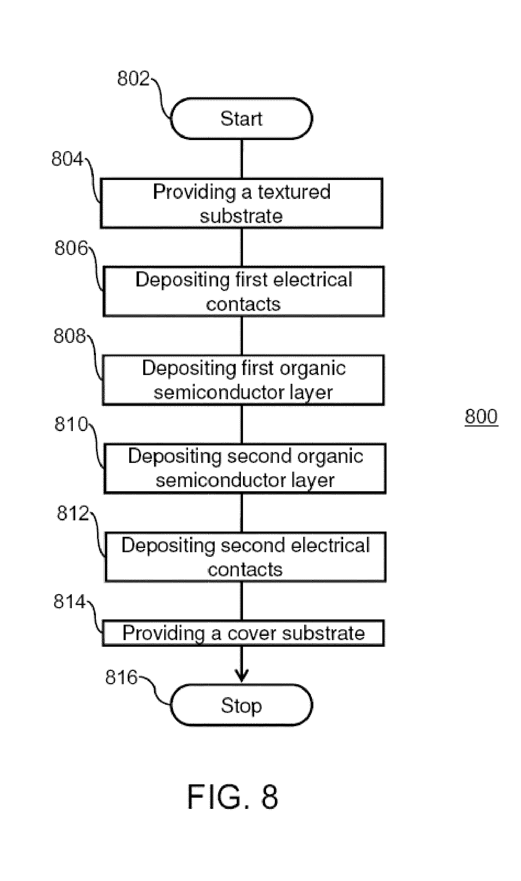

Referring now to FIG. 8, an exemplary method for manufacturing the OLED, for example, the OLED 600a, is provided. To describe the method 800, reference will be made to FIGs. 2, 3, 4, 5, 6, and 7, although it is understood that the method 800 can be implemented in any other suitable environment. Moreover, the invention is not limited to the order in which the steps are listed in the method 800. Further, it will also be apparent to those ordinarily skilled in the art that the method 800 may include one or more additional steps for further enhancement of the effectiveness of the method 800, however, are not essential to the method 800, in accordance with the present invention.

For the purpose of description, the method 800 has been explained in reference to an OLED and light extraction, however, it will be readily apparent to those ordinarily skilled in the art that the present invention can be implemented in an OPV as well for light management purposes, like, light trapping.

The method is initiated at step 802. At step 804, a textured substrate is provided. For example, the textured substrate can be the substrate 602. In an embodiment, the textured substrate can be prepared using the method 700 described in conjunction with FIG. 7.

Thereafter, at step 806, first electrical contacts are deposited on the textured substrate. For example, the first electrical contacts can be the first electrical contact 108 and can be deposited on the second surface 606 of the substrate 602. The first electrical contact 108 can be deposited by using various methods, such as dip coating, spin coating, doctored blade, spray coating, screen printing, sputtering, glass mastering, photoresist mastering, electroforming, and evaporation. In an embodiment, the first electrical contact 108 acts as an anode.

Thereafter, at step 808, a first semiconductor layer is deposited. For example, the first semiconductor layer can be the semiconductor layer 110. In an embodiment, the semiconductor layer 110 is a conductive type semiconductor layer, such that, it is capable of facilitating transport of holes from the first electrical contacts, i.e., the anode. Examples of a material used for the semiconductor layer 110 include, but are not limited to, polyaniline. The semiconductor layer 110 can be deposited by using various methods, such as dip coating, spin coating, doctored blade, spray coating, screen printing, sputtering, glass mastering, photoresist mastering, electroforming, and evaporation.

Thereafter, at step 810 a second semiconductor layer is deposited. For example, the second semiconductor layer can be the semiconductor layer 112. In an embodiment, the semiconductor layer 112 is an emissive type semiconductor layer, such that, it is capable of facilitating transport of electrons from the cathode. Example of a material used for the semiconductor layer 112 includes, but is not limited to, polyfluorene. The second semiconductor layer can be deposited by using various methods, such as dip coating, spin coating, doctored blade, spray coating, screen printing, sputtering, glass mastering, photoresist mastering, electroforming, and evaporation.

Thereafter, at step 812, second electrical contacts are deposited on the second semiconductor layer. For example, the second electrical contacts can be the second electrical contact 114 and can be deposited on the semiconductor layer 112. The second electrical contact 114 can be deposited by using various methods, such as dip coating, spin coating, doctored blade, spray coating, screen printing, sputtering, glass mastering, photoresist mastering, electroforming, and evaporation. In an embodiment, the second electrical contacts act as cathode.

Thereafter, at step 814, a cover substrate, for example, the cover substrate 116, is provided on the second electrical contact 114, such that the cover substrate 116 is joined to the substrate 602 and encapsulates the first electrical contacts 108, the one or more semiconductor layers 110 and 112, the second electrical contact 114 between itself and the substrate 602.

Thereafter, the method 800 terminates at step 816.

Various embodiments, as described above, provide a method to manufacture a substrate and a method for manufacturing a semiconductor device, which have several advantages. One of the several advantages is use of lesser number of layers in the semiconductor device since the substrate serves the function of light management, thereby making additional light extraction / light trapping layers surplus to requirements of the semiconductor device. This helps in reducing the cost of the semiconductor device. Also, the substrate formed by injection molding, according to the present invention, can replace the usually used glass substrate, thereby providing additional cost benefit. Another advantage is that the absence of the light extraction / light trapping layers reduces the chances of delamination of encapsulation. This further reduces or eliminates the entry of moisture or humidity into the semiconductor device, thereby preventing contamination of the semiconductor device.

Also, the light extraction / light trapping layers emit some gases and other fluids during the process of manufacturing or during the use of semiconductor device in high temperature conditions. The gases and other fluids tend to corrode the electrical contacts. Therefore, another advantage of the present invention is that it prevents the corrosion of the electrical contacts.

While the invention has been disclosed in connection with the preferred embodiments shown and described in detail, various modifications and improvements thereon will become readily apparent to those ordinarily skilled in the art. Accordingly, the present invention is not to be limited by the foregoing examples, but is to be understood in the broadest sense allowable by law. All documents referenced herein are hereby incorporated by reference.

## Claims

1. A method of manufacturing a substrate (602) for use in a semiconductor device (600a, 600b), said substrate (602) having a first surface (604) and a second surface (606), said method comprising:
providing a mold (200) having at least one of a first template (302) corresponding to a first texture and a second template (304) corresponding to a second texture; and
injection molding a material for making said substrate (602) in said mold, to form said substrate (602),
**characterized in that**
said material is injection molded to create at least one of said first texture on said first surface (604) and said second texture on said second surface (606), wherein at least one of said first texture and said second texture facilitate at least one of light extraction and light trapping in said semiconductor device (600a, 600b).

2. The method according to claim 1, wherein a refractive index of said substrate (602) is substantially equal to or greater than a refractive index of one or more semiconductor layers (110, 112) of said semiconductor device (600a, 600b) for optical homogeneity.

3. The method according to claim 1 or 2, wherein said material for making said substrate (602) is selected from the group comprising plastic, polycarbonate, polyethylene terephthalate (PET), and polyethylene naphthalate (PEN).

4. The method according to any of claims 1 to 3, wherein said semiconductor device (600a) is an Organic Light Emitting Device (OLED), and wherein said substrate (602) forms a base layer of said OLED (600a), and wherein said OLED (600a) has one or more semiconductor layers (110, 112) disposed on said substrate.

5. The method according to claim 4, wherein said second texture is capable of preventing reflection of light into said one or more semiconductor layers (110, 112) at an interface between said substrate (602) and said one or more semiconductor layers (110, 112), and wherein said first texture prevents reflection of light into said substrate (602) at an interface between said substrate (602) and an ambient medium.

6. The method according to any of claims 1 to 5, wherein said semiconductor device (600b) is an Organic Photovoltaic Device (OPV), and wherein said substrate (602) forms a base layer of said OPV (600b), and wherein said OPV (600b) has one or more semiconductor layers (110, 112) disposed on said substrate (602).

7. The method according to claim 6, wherein said second texture is capable of preventing reflection of light into said substrate (602) at an interface between said substrate (602) and said one or more semiconductor layers (110, 112), and wherein said first texture prevents reflection of light into an ambient medium at an interface between said substrate (602) and an ambient medium.

8. A semiconductor device (600a, 600b) comprising:
an injection molded substrate (602) having a first surface (604) and a second surface (606);
a first electrode (108) provided on said second surface (606) of said substrate (602);
one or more semiconductor layers (110, 112) provided on said first electrode (108);
a second electrode (114) provided on said one or more semiconductor layers (110, 112); and
a cover substrate (116) encapsulating said first electrode (108), said one or more semiconductor layers (110, 112) and said second electrode (114) between said substrate (602) and said cover substrate (116);
**characterized in that**
at least one of said first surface (604) and second surface (606) includes a first texture and a second texture, respectively, further wherein said first texture and said second texture facilitate at least one of light extraction and light trapping in said semiconductor device (600a, 600b).
